# EUROPEAN PATENT APPLICATION

(11) **EP 4 174 387 A1**
(43) Date of publication of application: **03.05.2023**
(21) Application number: 22201890.5
(22) Date of filing: 17.10.2022
(51) Int. Cl.: F24C 15/02, H05B 6/64, F24C 7/08

(54) **COOKING APPLIANCE**

(30) Priority: 28.10.2021 KR 20210146024; 03.02.2022 KR 20220013987
(71) Applicant: LG Electronics Inc., Seoul 07336 (KR)
(72) Inventor: LEE, Dongmin, 08592 Seoul (KR); BYUN, Jaewon, 08592 Seoul (KR); KIM, Ugjin, 08592 Seoul (KR)
(74) Representative: Ter Meer Steinmeister & Partner

(57) **Abstract**

One embodiment of a cooking appliance may include a main body formed with a cavity, and a door opening and closing the cavity. The door may include a display module disposed in front of the door, and a cooling flow path unit disposed behind the display module, and having a flow path through which air for cooling flows formed therein. The cooling flow path unit may include an air guide configured to guide the flow of the air introduced into the door, and a blowing device mounted on the air guide, and the air guide may include at least one inlet disposed on an upper portion, and through which external air is introduced, and a mounting hole formed under the inlet, and in which the blowing device mounted.

## Description

### BACKGROUND

### 1. Field of the Invention

The present invention relates to a cooking appliance, such as an oven or a microwave oven, and more specifically, to a cooking appliance configured to be installed above a heating cooking device, e.g. a cooking range.

### 2. Discussion of Related Art

The content described in this section merely provides background information on the present invention and does not constitute the related art.

A cooking appliance is a home appliance that cooks food using microwaves and/or heater heat, which are type(s) of electromagnetic waves. The cooking appliance may be generally composed of a cavity, which is a space in which food is placed and cooked, and a door that opens and closes the cavity.

The related art related to the cooking appliance is disclosed in Korean Patent Application Laid-Open No. 10-2008-0070408.

When the cooking appliance is installed indoors, it is necessary to consider the efficient use of the cooking appliance, the saving of installation space, etc.

For this reason, the cooking appliance may be disposed at a location adjacent to a heating cooking device, for example, a heating-type oven, a gas range, an electric range etc. Specifically, the cooking appliance may be disposed above the heating cooking device.

When the cooking appliance is disposed above the heating cooking device, a user can conveniently cook food by reducing his/her movement in an environment where the cooking appliance and the heating cooking device are adjacent to each other. In addition, heat, oil mist, etc. generated from the heating cooking device can be discharged to the outside using the cooking appliance as a hood.

In a state in which the cooking appliance is disposed above the heating cooling device, the heat, oil mist, etc. generated from the heating cooking device disposed below the cooking appliance may adversely affect an operation of the cooking appliance.

For example, a display unit may be mounted on a front surface of a door provided in the cooking appliance in order to provide various types of information to the user. The user may know a cooking state of the cooked food through the display unit.

In addition, when the display unit is connected to another home appliance and serves as a hub of the home appliance, information other than cooking of food may be obtained through the display unit. In addition, the user may input a command required for cooking and other various commands into the display unit through a touch method.

In the state in which the cooking appliance is disposed above the heating cooking device, the heat, oil mist, etc. generated from the heating cooking device may penetrate into the display unit and other parts mounted on the door.

It is necessary to suppress the display unit and other parts mounted on the door of the cooking appliance from being damaged or malfunctioning due to such heat, oil mist, etc.

### SUMMARY OF THE INVENTION

It is an object of the present invention to provide a cooking appliance having a display unit on a front surface in order to provide various types of information to the user.

In addition, it is an object of the present invention to provide a cooking appliance using microwaves and having a display unit provided on a door of the cooking appliance.

In addition, it is an object of the present invention to provide a cooking appliance having a structure or means capable of suppressing heat, oil mist, etc. generated from a heating cooking device disposed thereunder from penetrating into a door. In particular, it is an object of the present invention to provide a cooking appliance configured to be mounted above another cooking device, e.g. a cooktop range, the cooking appliance having means for suppressing heat, oil mist, etc. generated from a heating cooking device disposed thereunder from penetrating into a door.

In addition, it is an object of the present invention to provide a cooking appliance having a structure or means capable of preventing a display unit from being contaminated by oil mist.

In addition, it is an object of the present invention to provide a cooking appliance having a cooling structure for cooling a display module attached to a front surface of a door.

In addition, it is an object of the present invention to provide a cooking appliance having a structure or means capable of preventing heat, oil mist, etc. from penetrating into a door by forming an air curtain outside the door.

In addition, it is an object of the present invention to provide a cooking appliance having a door equipped with a display unit on a front surface thereof and formed with a cooling structure for cooling the display unit and/or a microwave shielding structure for preventing microwave leakage to the display unit.

In addition, it is an object of the present invention to provide a cooking appliance or means having a structure capable of effectively cooling parts mounted on a door.

The objects of the present invention are not limited to the above-described objects, and other objects and advantages not mentioned may be understood by the following description, and will be more clearly understood by the embodiments of the present invention. In addition, it will be easily seen that the objects and advantages of the present invention may be realized by the means described in the claims and combinations thereof. At least one of these objects is solved by the features of the independent claim.

According to an embodiment, a cooking appliance may include a main body formed with a cavity, and a door opening and closing the cavity.

The door may include a display module disposed in front of the door, a cooling flow path unit disposed behind the display module, and having a flow path through which air for cooling flows formed therein, and a shielding unit disposed behind the cooling flow path unit, and configured to shield electromagnetic waves generated from the main body.

According to an embodiment, a cooking appliance comprises: a main body in which a cavity is formed, and a door opening and closing the cavity, wherein the door includes a display module disposed in front of the door, and a cooling flow path unit disposed behind the display module, and having a flow path through which air for cooling flows formed therein, the cooling flow path unit includes an air guide configured to guide the flow of the air introduced into the door, and a blowing device mounted on the air guide, and the air guide includes at least one inlet disposed on an upper portion, and through which external air is introduced, and a mounting hole formed under the inlet, and in which the blowing device is mounted.

According to an embodiment, a cooking appliance comprises:

In the present disclosure, directional indications, such as "front", "rear", "upper", "lower" etc, may refer to an operational orientation of the cooking appliance. In particular a front surface of the door may define an exterior of the door, while a rear surface of the door may face the cavity in a closed state of the door. Likewise, a rear surface of any unit or module may refer to a surface facing away from the front surface of the door and/or to a surface facing the cavity.

The cooking appliance according to any one of these aspects may include one or more of the following features:

The cooking appliance may be a microwave cooking appliance, i.e. a cooking appliance using microwaves, such as a microwave oven. Here, a magnetron may be arranged in the main body for generating the microwaves.

The door, in particular the display module, may include: a first outlet disposed on an upper portion of the door for discharging air, e.g. air flowing inside the door, to the outside; and a second outlet disposed on a lower portion of the door for disharging air, e.g. air flowing inside the door, to the outside. That is, the door, in particular the display module, may include: a first outlet disposed on an upper portion, and through which the air, e.g. air flowing inside the display module or inside the door, is discharged to the outside; and a second outlet disposed on a lower portion, and through which the air, e.g. air flowing inside the display module or inside the door, is discharged to the outside. The first outlet may be configured to direct the air discharged therethrough downwards to flow along the display module. The second outlet may be configured to direct the air discharged therethrough towards a forward or front direction, i.e. in a direction perpendicular to the front surface of the door and pointing away from the door. The first and second outlet may be formed on a front surface of the door.

The air flowing through the cooling flow path unit may be branched from an inside of the cooling flow path unit to be discharged to the top and bottom of the display module, e.g. through the first and second outlet.

The door, in particular the display module, may include a display unit configured to display videos or images. The door, in particular the display module, may include an outer panel disposed behind the display unit and on which the display unit is mounted. The door, in particular the cooling flow path unit, may include an inner panel disposed behind the outer panel and mounted on the outer panel. The air guide may be disposed between the outer panel and the inner panel, and/or may be coupled to the inner panel. The door, in particular the cooling flow path unit, may include a blowing device mounted on the air guide. The outer panel may form an outer appearance of the door. In particular, the outer panel and the display unit may form the front surface of the door. The blowing device may be arranged at a central portion of the door and/or of the cooling flow path unit and/or of the air guide. The outer panel may include at least one aperture formed in an upper surface of the outer panel to allow air to enter the door.

The cooling flow path unit may include at least one inlet disposed on an upper portion of the air guide to allow air to be introduced into the door and/or into the cooling flow path unit. A mounting hole for mounting the blowing device may be provided below the inlet. That is, the air guide may include at least one inlet disposed on an upper portion, and through which external air is introduced. The air guide may include a mounting hole formed under the inlet, and in which the blowing device is mounted.

The inlet may be formed in vertical direction or in an up-down direction of the air guide, and/or the mounting hole may be formed in a horizontal direction or in a front-rear direction of the air guide. That is, the inlet may be formed to guide air in vertical direction. The mounting hole may be formed to penetrate the air guide in horizontal direction, i.e. in front-rear direction. Thus, the air guide is configured to allow air to be introduced through the inlet to flow along a rear surface of the air guide, i.e. to flow between the air guide and the inner panel, and to allow the air to pass from the rear surface through the mounting hole to a front surface of the air guide, i.e. to flow between the air guide and the display module.

The blowing device may include a casing disposed in the mounting hole, and a blowing fan rotatably mounted in the casing. The blowing device, in particular the blowing fan, may be configured for blowing or flowing air from the rear to a front of the air guide.

The door may include a first outlet disposed on an upper portion thereof to discharge the air to the outside of the door or cooking appliance, and/or a second outlet disposed on a lower portion to discharge the air to the outside of the door or cooking appliance. In particular, the outer panel may include a first outlet disposed on an upper portion thereof to discharge the air flowing by the blowing device to the outside, and/or a second outlet disposed on a lower portion thereof to discharge the air flowing by the blowing device to the outside. The second outlet may be formed on a front side or surface of the door. The first outlet (121) and/or the second outlet (124) may be configured for discharging the cooling air in forward or front direction.

The air forcibly flowing by the blowing fan may specifically have the following flow path.

The air forcibly flowing by the blowing fan may be introduced from the inlet to flow in a downward direction of the door to be introduced into the blowing fan, may pass through the blowing fan in a front-rear direction of the door, and may be branched in an up-down direction in front of the air guide, a part of which may flow in an upward direction of the door to be discharged through the first outlet, and the other part of which may flow in the downward direction of the door to be discharged through the second outlet.

A first aperture into which external air flows may be formed at a location corresponding to the inlet on an upper surface of the outer panel. That is, the door, in particular the outer panel, may include a first aperture formed in an upper surface thereof corresponding to the inlet of the air guide to allow external air to be introduced through the upper surface into the door and/or into the air guide. The upper surface of the outer panel may form at least a portion of the upper surface of the door.

The air guide and the inner panel may form a first space having the inlet formed therein by being coupled to each other. The air guide and the inner panel may further form a second space disposed under the first space and in which the blowing device is mounted. The second space may be communicating with or connected to the first space. The second space may be defined in the mounting hole.

A third space through which the air passing through the blowing fan is introduced and distributed to flow toward the first outlet and the second outlet may be formed between the air guide and the outer panel.

A cross-sectional area (e.g. in a horizontal plane) of the first space may be provided to increase from a bottom toward a top of the door. That is, a dimension of the first space in front-rear direction may increase towards an upper side of the door and/or of the air guide.

A cross-sectional area (e.g. in a horizontal plane) of the third space may be provided to increase from the bottom toward the top of the door at a boundary point between the first space and the second space. A cross-sectional area (e.g. in a horizontal plane) of the third space may decrease from the mounting hole towards an upper side of the door and/or of the air guide.

The mounting hole may communicate the second space with the third space, and the blowing fan may flow the air from the second space to the third space.

The air guide may include an inclined portion disposed to be inclined in an up-down direction to increase the cross-sectional area from a bottom toward a top of the air guide.

The air guide may include a guide fin provided to protrude from an inner wall, i.e. rear surface, of the air guide at a location where the first space is formed, disposed so that a longitudinal direction faces the mounting hole, and guiding the air introduced into the inlet to flow into the mounting hole.

The door may further include a shielding unit disposed behind the cooling flow path unit, and configured for shielding electromagnetic waves generated in the main body. The door, in particular the shielding unit, may further include a shielding plate coupled to a rear surface of the cooling flow path unit, e.g. to the inner panel. The shielding plate may be disposed behind the inner panel and/or may be coupled to the inner panel and/or may have one side rotatably coupled to the main body. The door, in particular the shielding unit, may further include a choke member at a rear side of the shielding plate, the choke member being configured to block electromagnetic waves.

The door may include a front cover and/or a baffle. The front cover may cover an outer circumferential portion of the front surface of the door. The front cover and/or the baffle may at least partially cover a front surface of the outer panel. In particular, the front cover and/or the baffle may cover the first outlet formed in the outer panel such that air discharged through the first outlet is guided downwards. The baffle may cover an edge of the front surface of the display unit and/or may couple the display unit to the outer panel. The front cover may cover at least a portion of the baffle.

That is, the door, in particular the display module, may further include a baffle disposed in front of the display unit, surrounding an edge of the display unit, and coupled to the outer panel to mount the display unit on the outer panel. The door, in particular the display module, may further include a front cover disposed in front of the baffle, and provided to surround an edge of the baffle.

The door may further include at least one of: a first camera mounted on a lower portion of the outer panel to capture a state of a lower portion of the door, a second camera disposed on an upper portion of the door, mounted by passing through the baffle and the front cover, and capturing a front of the door, and a third camera mounted on the shielding plate, disposed to face the cavity, and capturing the cavity.

The door may further include a human detection unit disposed on the upper portion of the door, mounted by passing through the baffle and the front cover, disposed at a location spaced apart from the second camera, and detecting the presence of a user in front of the cooking appliance.

In the cooking appliance according to an embodiment of the present invention, since the display module is provided on the front of the door, the user can know the cooking situation in the cooking appliance through the display module. The display module can serve as the hub of another home appliance to provide various types of information to the user, thereby enhancing the user's convenience.

In addition, in the cooking appliance according to an embodiment of the present invention, the air branched from the first outlet and the second outlet can surround the entire door. In particular, the branched air can surround the front portion of the door. This structure can allow the air discharged from the first outlet and the second outlet to form an air curtain on the door, thereby effectively suppressing the heat and oil mist generated from the heating cooking device disposed below the cooking appliance from permeating into the door.

Accordingly, it is possible to effectively suppress various electronic parts including the display unit provided on the door from being damaged or degraded by the heat and the oil mist. In addition, it is possible to prevent the display unit from being contaminated by the heat and the oil mist and thus giving inconvenience to the user.

In addition, in the cooking appliance according to an embodiment of the present invention, the air flowing inside the door can be discharged through the first outlet to cool the entire front surface of the display unit. In addition, the air flowing inside the door can effectively cool the heat-generating parts mounted on the rear surface of the display unit and inside the door.

In addition, in the cooking appliance according to an embodiment of the present invention, since the cross-sectional areas of the inlet and the first space increase, the external air can smoothly flow into the first space through the inlet. Accordingly, it is possible to smoothly flow the air into the door, and increase the cooling effect and the air curtain forming effect of the door.

In addition, in the cooking appliance according to an embodiment of the present invention, the guide fin can be mounted on the air guide to guide the flow of the air, so that the air introduced through the inlet can be smoothly moved to the mounting hole.

In addition, in the cooking appliance according to an embodiment of the present invention, a door having all of the display structure, the cooling structure, and the shielding structure of the electromagnetic waves can be formed. The display structure, the cooling structure, and the shielding structure can be coupled to one another to slimly form the door as a whole. Accordingly, it is possible to prevent the thickness of the door from being increased even when all of the display structure, the cooling structure, and the shielding structure are formed on the door.

Detailed effects of the present invention in addition to the above-described effects will be described together with the description of the specific items for practicing the present invention below.

### BRIEF DESCRIPTION OF THE DRAWINGS

FIG. 1 is a perspective view showing a cooking appliance according to one embodiment;
FIG. 2 is a view showing a state in which a door in FIG. 1 has been opened;
FIG. 3A is a perspective view showing a door of the cooking appliance according to one embodiment;
FIG. 3B is a view of FIG. 3A from another direction;
FIG. 4A is a rear view of the door;
FIG. 4B is an exploded perspective view showing a part of the door according to one embodiment;
FIG. 4C is a view of FIG. 4B from another direction;
FIG. 5 is an exploded perspective view of the door according to one embodiment;
FIG. 6 is a view of FIG. 5 from another direction;
FIG. 7 is a side cross-sectional view of the door according to one embodiment;
FIG. 8 is a perspective view showing an outer panel according to one embodiment;
FIG. 9A is a rear view showing the outer panel according to one embodiment;
FIG. 9B is a view of FIG. 8 from another direction;
FIG. 10 is an exploded perspective view of a display unit and the outer panel;
FIG. 11 is a view showing an inner panel and an air guide according to one embodiment;
FIG. 12 is an exploded perspective view of FIG. 11;
FIG. 13 is a view of FIG. 12 from another direction;
FIG. 14 is an exploded perspective view showing the inner panel and the air guide in the door.

### DETAILED DESCRIPTION OF EXEMPLARY EMBODIMENTS

The above-described objects, features, and advantages will be described below in detail with reference to the accompanying drawings, and accordingly, those skilled in the art to which the present invention pertains will be able to easily practice the technical idea of the present invention. In describing the present invention, when it is determined that a detailed description of a known technique related to the present invention may unnecessarily obscure the gist of the present invention, the detailed description will be omitted. Hereinafter, embodiments according to the present invention will be described in detail with reference to the accompanying drawings. In the drawings, the same reference numerals are used to indicate the same or similar components.

Although the first, second, etc. are used to describe various components, it goes without saying that these components are not limited by these terms. These terms are only used to distinguish one component from other components, and unless otherwise stated, it goes without saying that the first component may also be the second component.

Throughout the specification, unless specifically stated otherwise, each component may be singular or plural.

As used herein, the singular expression includes the plural expression unless the context clearly dictates otherwise. In the present application, terms such as "consisting of" or "comprising" should not be construed as necessarily including all of the various components or various steps described in the specification, and should be construed that some components or some steps may not be included, or additional components or steps may be further included.

Throughout the specification, when "A and/or B" is used, it means A, B or A and B, unless specifically stated otherwise, and when "C to D" is used, it means greater than or equal to C and smaller than or equal to D unless specifically stated otherwise.

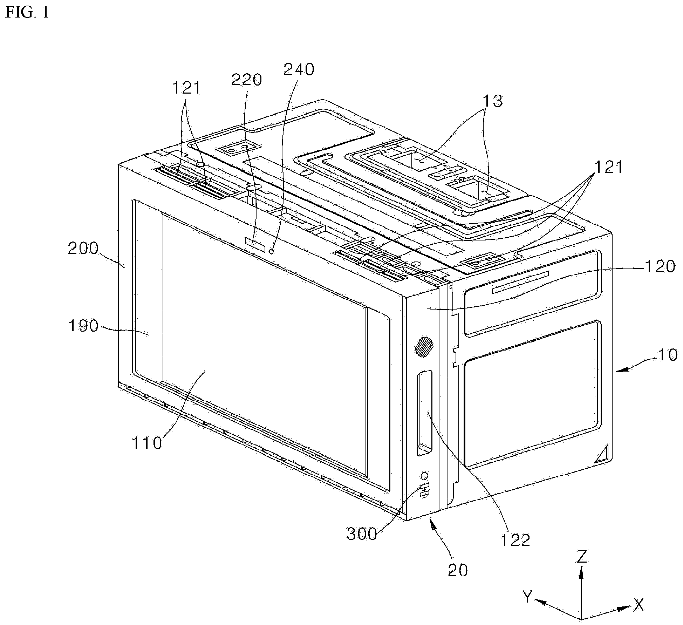

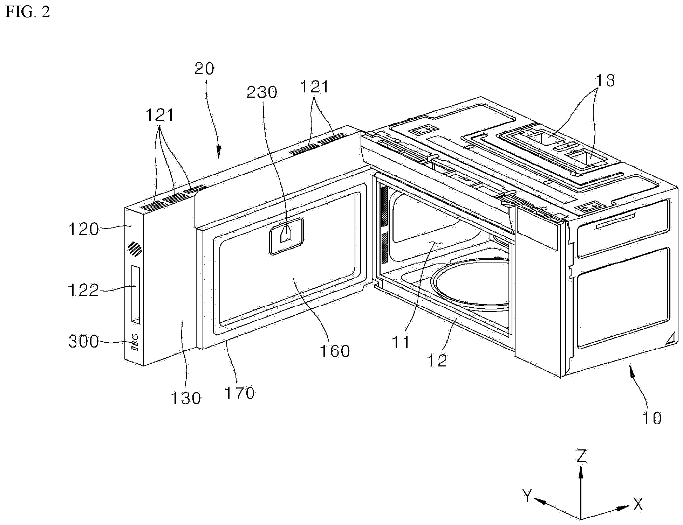

FIG. 1 is a perspective view showing a cooking appliance according to one embodiment. FIG. 2 is a view showing a state in which a door 20 in FIG. 1 has been opened.

The cooking appliance according to the embodiment may be disposed at a location spaced apart from a heating cooking device in an up-down direction above a location where the heating cooking device, for example, a heating-type oven, a gas range, etc. is disposed.

The placement of the cooking appliance can allow a user to conveniently use cooking devices including the cooking appliance. In addition, the cooking appliance may serve as a hood of the heating cooking device disposed thereunder. In this case, the cooking appliance may be provided with parts for use as a hood.

The cooking appliance may cook food using microwaves and/or heater heat, which are type(s) of electromagnetic waves. The cooking appliance may include a main body 10 in which a cavity 11 is formed, and a door 20 that opens and closes the cavity 11.

Food to be cooked may be placed in the cavity 11. The door 20 may be disposed in front of the cavity 11 and rotatably mounted on the main body 10 to open and close the cavity 11.

A vent hole 13 for discharging the air sucked in a suction unit provided on a lower portion of the main body 10 to the outside may be provided in an upper portion of the main body 10. The suction unit may be provided at a lower portion of the main body 10 of the cooking appliance. Accordingly, the cooking appliance may serve as a hood for sucking the air discharged from the heating cooking device disposed thereunder to discharge the air to the outside.

The main body 10 may further include a front panel 12 provided on an edge of the entrance of the cavity 11, and having one surface disposed to face one surface of a choke member 170 when the door 20 is closed to close the cavity 11.

The front panel 12 may be provided to surround the edge of the entrance of the cavity 11 and protrude with a predetermined width. Accordingly, when the door 20 is closed, the edge portion of the door 20 and the cavity 11 may overlap each other.

This structure can allow the front panel 12 to seal the cavity 11 in a state in which the door 20 is closed, thereby suppressing the oil, moisture, oil mist, etc. generated in the process of cooking food placed in the cavity 11 from being discharged to the outside through an inlet of the cavity 11.

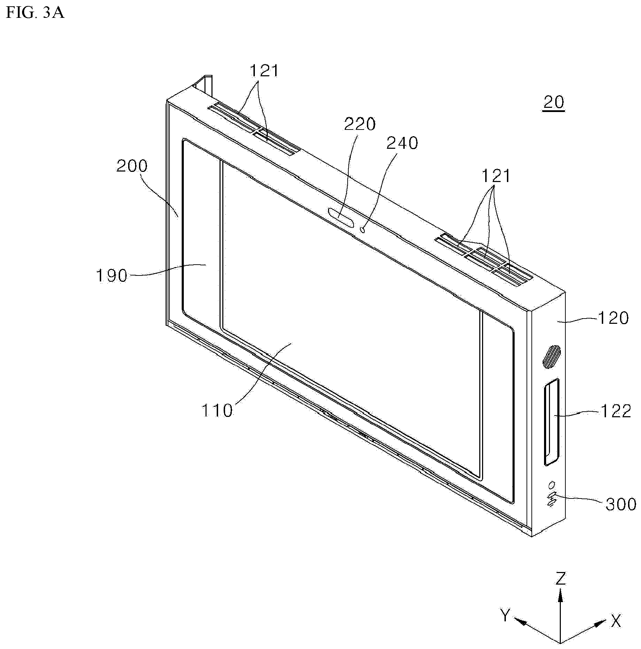

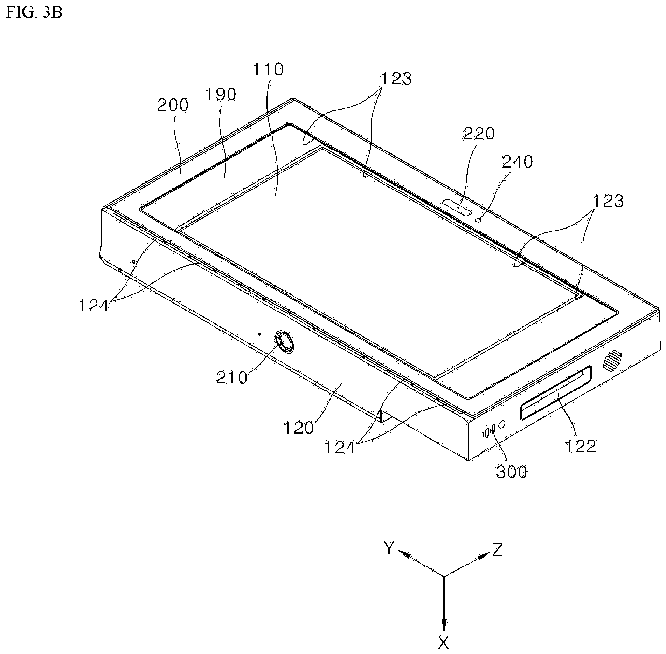

FIG. 3A is a perspective view showing the door 20 of the cooking appliance according to one embodiment. FIG. 3B is a view of FIG. 3A from another direction.

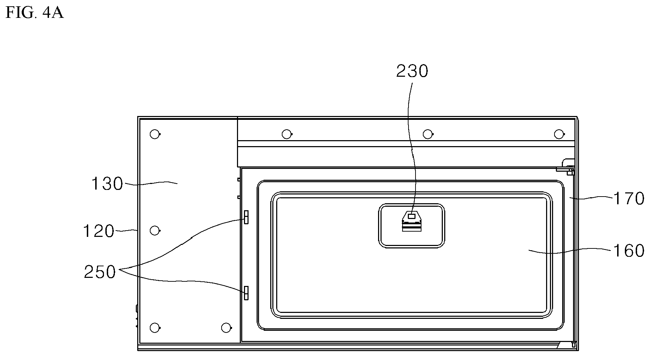

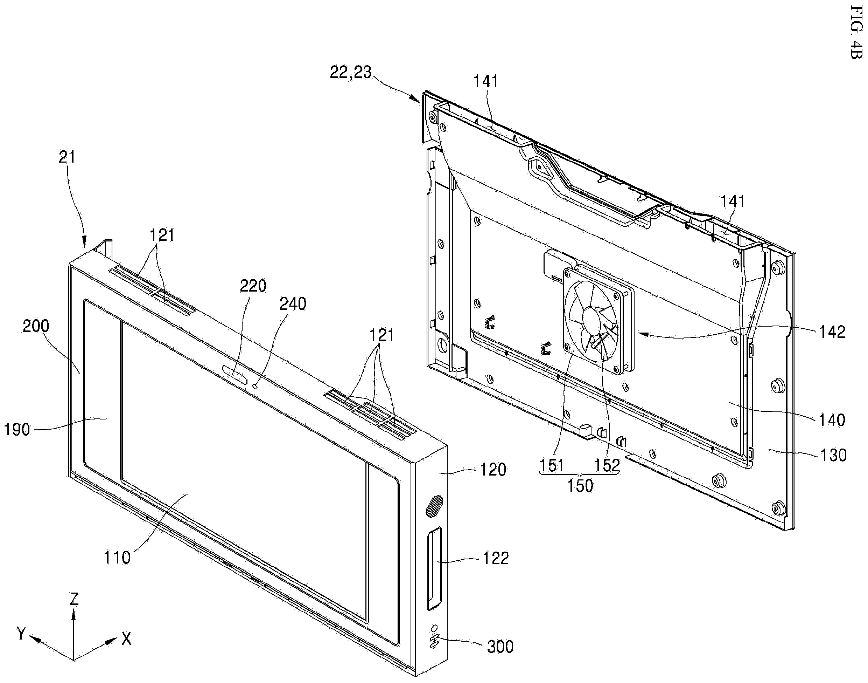

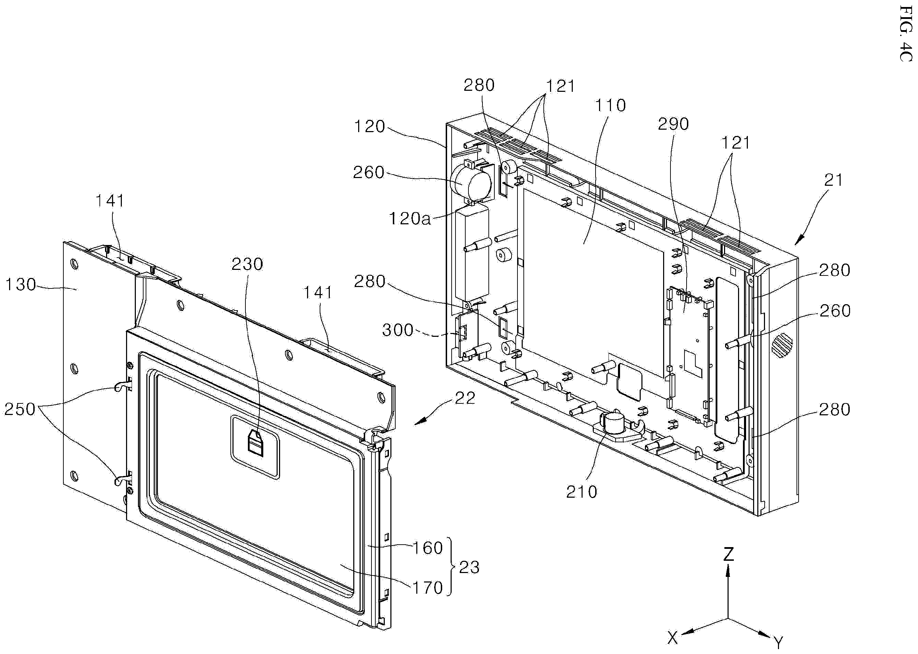

FIG. 4A is a rear view of the door 20. FIG. 4B is an exploded perspective view showing a part of the door 20 according to one embodiment. FIG. 4C is a view of FIG. 4B from another direction.

The door 20 may include a display module 21, a cooling flow path unit 22, and a shielding unit 23. The display module 21 may be disposed in front of the door 20, and the user may see the inside of the cavity 11 of the cooking appliance through the display module 21.

The cooling flow path unit 22 may be disposed behind the display module 21, and a flow path through which air for cooling flows may be formed therein. The air flowing into the door 20 may flow into the door 20 through the cooling flow path unit 22 to cool the door 20.

The shielding unit 23 may be disposed behind the cooling flow path unit 22, and may shield electromagnetic waves generated from the main body 10. The shielding unit 23 may protect the user by blocking the electromagnetic waves generated in the cavity 11 and propagating to the outside of the cooking appliance.

For example, the shielding unit 23 may serve to block the electromagnetic waves (microwaves) generated to cook food in the main body 10 from being discharged to the outside of the door 20.

The cooling flow path unit 22 may be provided to cool electronic components mounted inside the door 20, including a display unit 110 mounted on the display module 21. The air for cooling the door 20 may flow inside the cooling flow path unit 22. The display unit 110 may be formed in a thin shape and provided so that an area of the display unit 110 occupies most of one surface of the door 20.

Accordingly, the display unit 110 can be formed to occupy most of the area of the front portion of the door 20, and the placement area of the display unit 110 can be increased, thereby improving user visibility. The user may conveniently check various types of information through the display unit 110 provided with a large screen.

Since the size of the display unit 110 is increased, the amount of heat generated may increase. Accordingly, the display unit 110 in the door 20 needs to be effectively cooled. In the embodiment, the cooling flow path unit 22 through which the cooling air flows may be separately provided.

The cooling flow path unit 22 may be disposed behind the display unit 110 so that cooling air flows, and thus the display unit 20 may be effectively cooled by the air flowing through the cooling flow path unit 22. In addition, a heat-generating part mounted on the display module 21 may be cooled by the air flowing through the cooling flow path unit 22. In other words, the cooling flow path unit 22 may cool the display module 21 provided with the display unit 110 and other various heat-generating parts.

In order to effectively cool the display unit 110, the entire display unit 110 may be provided to be exposed to the air flowing through the cooling flow path unit 22. In addition, the airflow discharged to the outside of the door 20 through the cooling flow path unit 22 may form an air curtain to block heat and oil mist rising from the heating cooking device disposed below the cooking appliance.

To this end, the air flowing through the cooling flow path unit 22 may be branched inside the cooling flow path unit 22 to be discharged to the top and bottom of the display module 21.

The cooling air is branched inside the cooling flow path unit 22 and discharged to the top and bottom of the display module 21, so that the cooling air can flow while in contact with the entire rear surface of the display unit 110 to effectively cool the display unit 110.

In addition, the cooling air is discharged to each of the top and bottom of the display module 21 to effectively form the air curtain around the display and the door 20, so that the heat and oil mist rising from the heating cooking device disposed below the cooking appliance can be effectively blocked by the air curtain.

The display module 21 may be provided with the display unit 110, a camera, and other electronic parts, and the cooling flow path unit 22 may be provided with electronic parts such as a blowing device 150 operated by a motor. Accordingly, the shielding unit 23 configured to shield the electromagnetic waves generated from the main body may be provided behind the cooling flow path unit 22 in order to protect the user and the electronic parts from electromagnetic waves.

The display unit 110 and various electronic parts may be disposed in the display module 21, the cooling flow path unit 22 in which the flow path of the air for cooling the display module 21 is formed may be disposed behind the display module 21, and the shielding unit 23 configured to shield electromagnetic waves from reaching the electronic parts provided in the display module 21 may be disposed behind the cooling flow path unit 22.

In the embodiment, the display module 21 configured to provide various types of information and convenience to the user may be disposed on the front surface of the cooking appliance, that is, on the front of the door 20. In addition, in the embodiment, there is a need for a structure that effectively cools the parts such as the display unit 110 provided in the display module 21, effectively cools the inside of the door 20 provided with the display unit 110 and the like, and at the same time, forms the flow path of the cooling air for forming the air curtain around the door 20, and also protects the electronic parts mounted on the door 20 from electromagnetic waves.

In order to satisfy this need, the display module 21 may be disposed at the front of the door 20, the cooling flow path unit 22 may be disposed behind the display module 21, and the shielding part 23 may be disposed behind the cooling flow path unit 22.

In other words, in order to implement the door structure according to the above-described embodiment, the display module 21, the cooling flow path unit 22, and the shielding unit 23 that play their own roles may be sequentially disposed on the door 20 from the front to rear in the door 20.

In addition, the display module 21, the cooling flow path unit 22, and the shielding unit 23 may be provided to be stably coupled to each other to prevent the cooling air from flowing out to the outside of the door 20 through other portions other than a first outlet 123 disposed at an upper portion of the display module 21 and a second outlet 124 at a lower portion of the display module 21. Hereinafter, the door 20 implemented using the above-described structure will be described in detail.

The display module 21 may include the first outlet 123 and the second outlet 124. The first outlet 123 may be disposed at the upper portion of the display module 21, and the air flowing inside the display module 21 may be discharged to the outside through the first outlet 123.

The second outlet 124 may be disposed at the lower portion of the display module 21, and the air flowing inside the display module 21 may be discharged to the outside through the second outlet 124. In other words, the air flowing inside the door 20 may be discharged to the outside through the first outlet 123 and the second outlet 124 respectively disposed at upper and lower portions of the door 20, so that the air can flow through the entire inside of the door 20 to effectively cool the entire door 20.

The display module 21 may include the display unit 110 and an outer panel 120. The display unit 110 may be disposed on the front surface of the door 20 to display videos or images.

The display unit 110 may display information necessary for cooking to provide the information to the user. In addition, the display unit 110 may receive a user's command in a touch recognition method.

Meanwhile, the display unit 110 may be connected to communicate with other home appliances, and cameras, locks, etc. provided in the front door. In addition, the display unit 110 may be connected to communicate with an external device required by the user.

The user may receive information necessary for operations of home appliances, visits by outsiders, and other aspects of daily life from the display unit 110, and transmit commands to home appliances and other devices connected to the display unit 110 using the display unit 110.

Accordingly, the door 20 including the display unit 110 may serve as a kind of Internet of Things hub that transmits information about home appliances and other devices necessary for daily life to the user, and transmits the user's commands to these devices.

The outer panel 120 may be disposed behind the display unit 110, and the display unit 110 may be mounted thereon. The outer panel 120 may have a hollow 1201 and may be provided in a shape having a predetermined width in the front-rear direction of the door 20.

The hollow 1201 of the outer panel 120 may be closed by the rear surface of the display unit 110. The air flowing inside the outer panel 120 may collide with the rear surface of the display unit 110 exposed to the hollow 1201 of the outer panel 120. Accordingly, the air flowing inside the outer panel 120 may come into contact with the rear surface of the display unit 110 to cool the display unit 110.

In addition, the air passing through a blowing fan 152 may be exposed to the hollow 1201 of the outer panel 120 to cool heat-generating parts such as a speaker 260, a microphone 270, a communication unit 280, and a control board 290 to be disposed.

Since the outer panel 120 has the above-described structure, the outer panel 120 may have an interior space, and various parts may be built in the interior space. A width in the front-rear direction of the door 20 may be substantially determined by the outer panel 120.

A first aperture 121 into which air flows may be formed at a location corresponding to an inlet 141 in an upper surface of the outer panel 120. A plurality of first apertures 121 may be provided.

Each of the first apertures 121 may be provided so that a plurality of slit-shaped holes are arranged at intervals. This structure can somewhat suppress foreign substances from flowing into the door 20 through the first aperture 121.

A handle 122 may be provided on one side of the outer panel 120 to be used when the user opens and closes the door 20. The handle 122 may be formed, for example, by recessing a side portion of the outer panel 120.

A button device 300 may be mounted on one side of the outer panel 120, for example, just below a location where the handle 122 is formed. The user may supply electricity to the cooking appliance or cut off the electricity supply by manipulating the button device 300. Specific manipulation for the operation of the cooking appliance is possible by inputting commands into the display unit 110.

The outer panel 120 may support various parts such as the display unit 110, the speaker 260, the microphone 270, the communication unit 280, and the control board 290, and may be formed with the first aperture 121 into which external air flows, and the first outlet 123 and the second outlet 124 through which air is discharged.

Meanwhile, the door 20 may be provided with a camera. The images captured by the camera may be reproduced on the display unit 110, and the user may view images inside the cavity 11 or of the lower portion of the cooking appliance through the display unit 110. The camera may include a first camera 210, a second camera 220, and a third camera 230.

The first camera 210 may be mounted on a lower portion of the outer panel 120 to capture a state of the lower portion of the door 20. Since the first camera 210 is mounted on the lower portion of the outer panel 120 so that a gaze direction faces the lower portion of the cooking appliance, the first camera 210 may capture the heating cooking device disposed below the cooking appliance.

The user may observe the state of the heating cooking device and the state of food being cooked on the heating cooking device by the image captured by the first camera 210 and reproduced on the display unit 110.

The second camera 220 may be disposed on the upper portion of the door 20 and may capture the front of the door 20. The second camera 220 may capture the front of the cooking appliance.

The second camera 220 may be provided to pass through a baffle 190 and a front cover 200, which will be described below. The user may observe the situation in front of the cooking appliance captured and recorded by the second camera 220.

Meanwhile, the second camera 220 may capture the user in front of the cooking appliance. Accordingly, the second camera 220 may be used for the user to make a video call with other people in a remote location outside the front door using the display unit 110.

The third camera 230 may be mounted on a shielding plate 160 to be described below, may be disposed to face the cavity 11, and may capture the cavity 11. In other words, the gaze of the third camera 230 may be provided to face the cavity 11 to capture the situation of the cavity 11. The user may observe a situation in which food is cooked in the cavity 11 through the image captured by the third camera 230.

The door 20 may include a human detection unit 240 disposed on the upper portion of the door 20, mounted by passing through the baffle 190 and the front cover 200, disposed at a location spaced apart from the second camera 220, and configured to detect the presence of the user in front of the cooking appliance.

The human detection unit 240 may detect whether there is a person in front of the door 20 by, for example, infrared recognition or gesture recognition. A control unit provided in the cooking appliance may identify whether there is a user in front of the cooking appliance through the human detection unit 240.

When there is a user, for example, the control unit may operate the display unit 110 to activate the functions of the cooking appliance necessary for the user's convenience and safety by taking an action to enable the user to use the display unit 110 immediately.

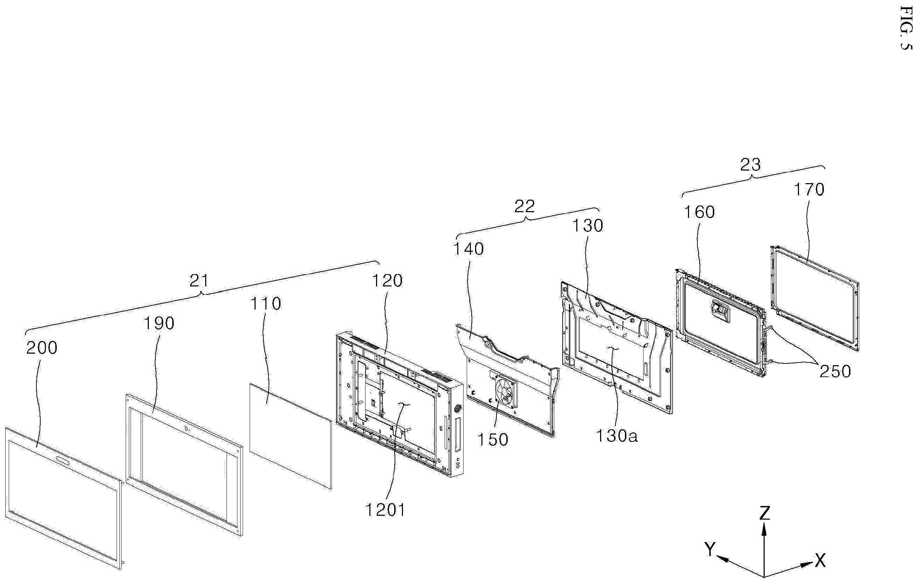

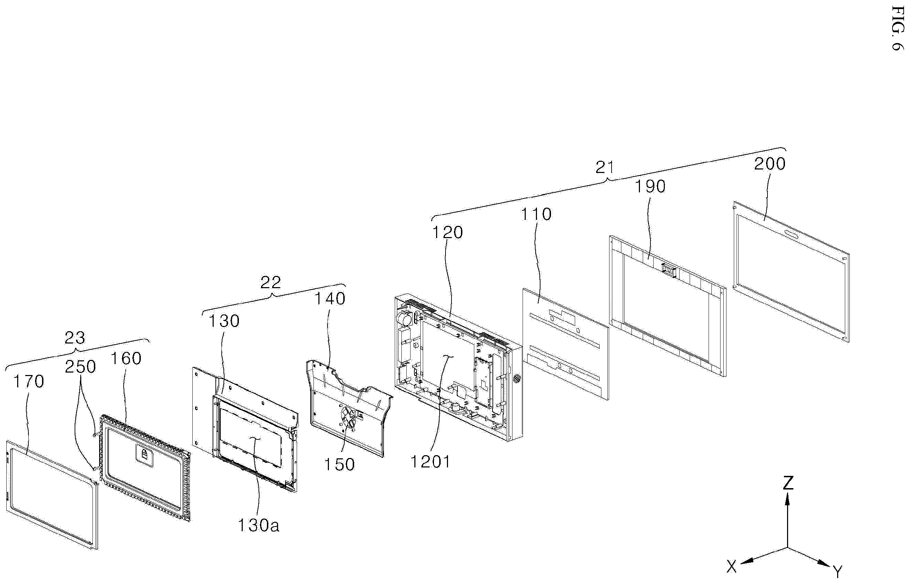

FIG. 5 is an exploded perspective view of the door 20 according to one embodiment. FIG. 6 is a view of FIG. 5 from another direction. The cooling flow path unit 22 may include an inner panel 130, an air guide 140, and a blowing device 150.

The inner panel 130 may be disposed behind the display module 21. The inner panel 130 may be disposed behind the outer panel 120 and mounted on the outer panel 120. The air guide 140 to be described below may be mounted on the inner panel 130. The inner panel 130 along with the air guide 140 may form a space in which the air sucked into the door 20 flows. The inner panel 130 may be mounted with the air guide 140 and coupled to the shielding plate 160 to provide the space in which the air flowing into the door 20 flows.

The air guide 140 may be disposed between the display module 21 and the inner panel 130. The air guide 140 may be disposed between the outer panel 120 and the inner panel 130, and coupled to the inner panel 130. The air guide 140 may guide the flow of air flowing into the door 20 from the outside, and form the space in which the air may flow. The inner panel 130 and the air guide 140 may be coupled to each other to form the flow path of air.

The blowing device 150 may be mounted on the air guide 140. The blowing device 150 may forcibly flow the air introduced into the air guide 140 from the rear to the front of the air guide 140. The blowing device 150 may include a casing 151 and the blowing fan 152 mounted on the casing 151 to flow the air from the rear of the front of the air guide 140.

The shielding unit 23 may include the shielding plate 160 and the choke member 170. The shielding plate 160 may be disposed behind the inner panel 130, may be coupled to the inner panel 130, and may have one side rotatably coupled to the main body 10. As the shielding plate 160 rotates, the door 20 may be rotated to open and close the cavity 11 of the cooking appliance.

The shielding plate 160 may be coupled to the inner panel 130 to form a flow path of air for cooling and at the same time, may form an inner surface of the door 20 with a shielding structure for preventing the leakage of electromagnetic waves, that is, the choke member 170.

The choke member 170 may be disposed behind the shielding plate 160, may be coupled to the shielding plate 160, and may block the electromagnetic waves generated from the main body 10 from being discharged to the outside. The choke member 170 may be generally provided in a quadrangular shape having a hollow, and provided to surround an edge portion of the shielding plate 160.

The display module 21 may further include the baffle 190 and the front cover 200. The baffle 190 may be disposed in front of the display unit 110, may surround the edge of the display unit 110, and may be coupled to the outer panel 120 to mount the display unit 110 on the outer panel 120.

The baffle 190 is generally formed in a quadrangular shape having a hollow to surround the edge of the display unit 110, and thus may serve as a bezel of the display unit 110.

The front cover 200 may be disposed in front of the baffle 190, and provided to surround the edge of the baffle 190. The front cover 200 may be generally formed in a quadrangular shape having a hollow, and may serve to stably couple the display unit 110 and the baffle 190 to the outer panel 120.

The door 20 may include a latch 250 mounted on the side of the shielding plate 160, which has a part formed to protrude from the shielding plate 160. The latch 250 may be formed in a structure that is caught in a groove formed in the front panel 12 of the door 20. The latch 250 may stably maintain the state in which the door 20 is closed.

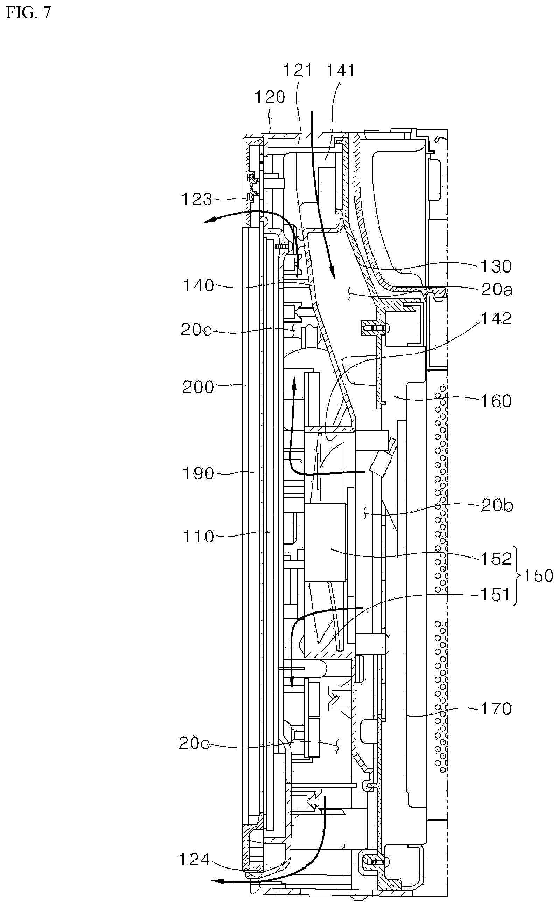

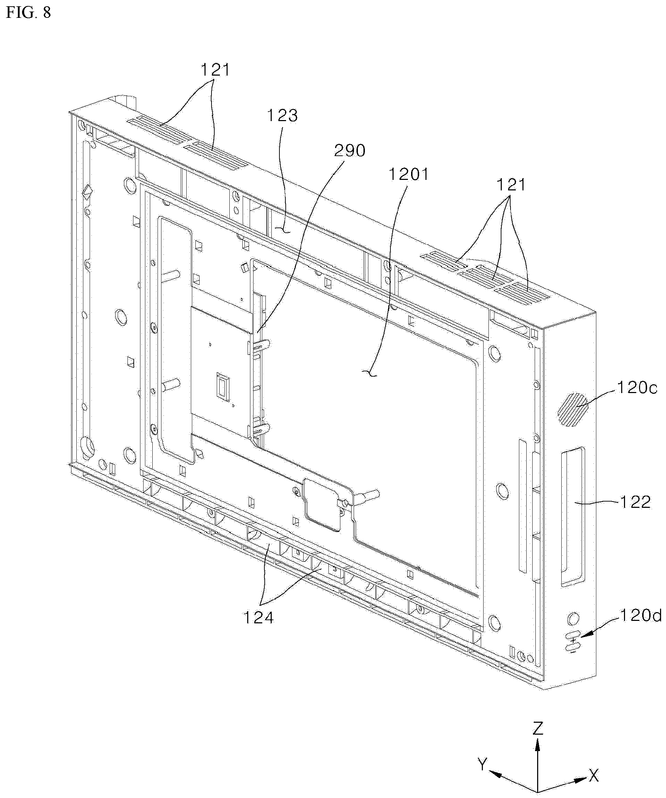

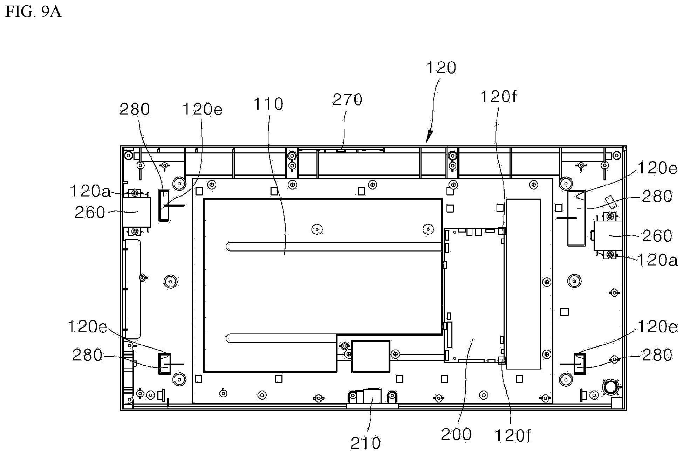

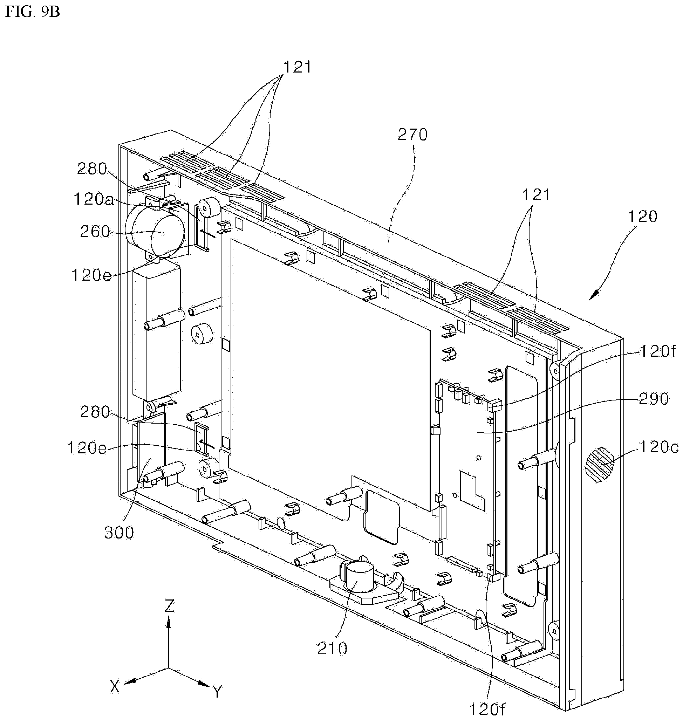

FIG. 7 is a side cross-sectional view of the door 20 according to one embodiment. FIG. 8 is a perspective view showing the outer panel 120 according to one embodiment. FIG. 9A is a rear view showing the outer panel 120 according to one embodiment. FIG. 9B is a view of FIG. 8 from another direction.

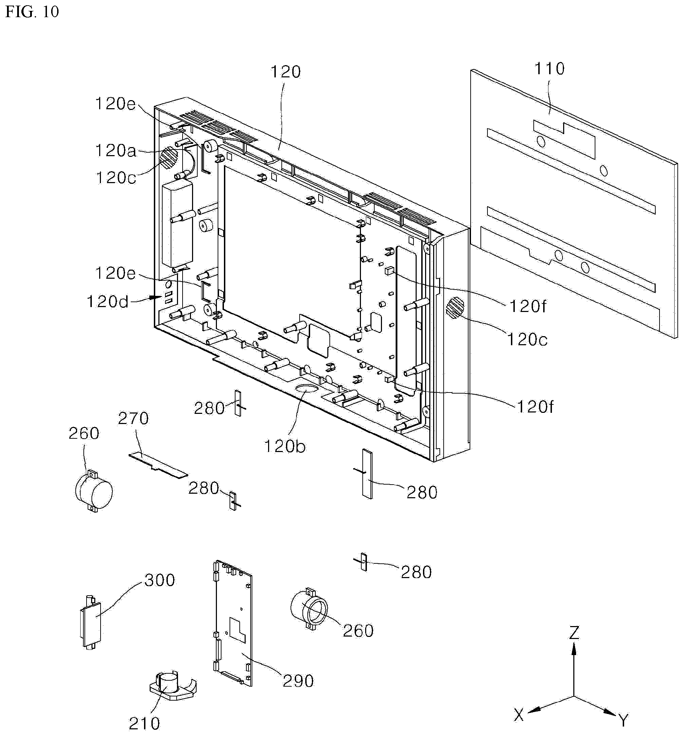

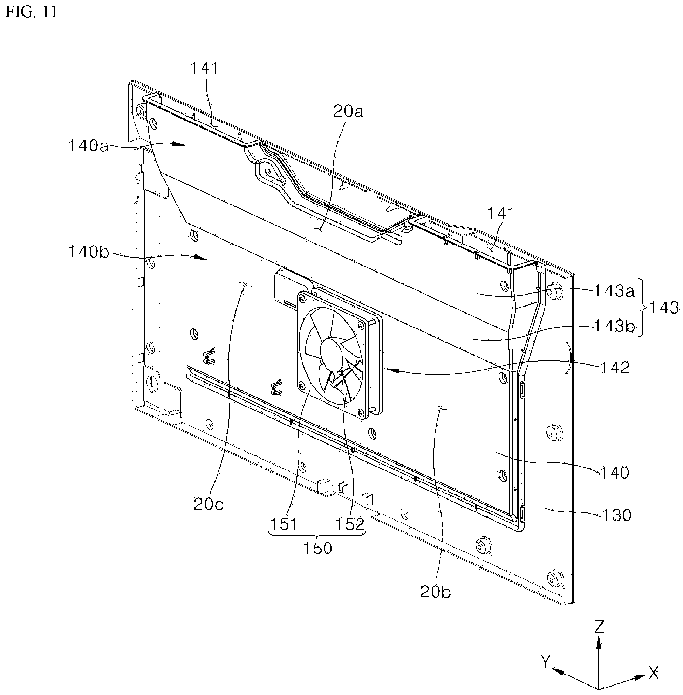

FIG. 10 is an exploded perspective view of the display unit 110 and the outer panel 120. FIG. 11 is a view showing the inner panel 130 and the air guide 140 according to one embodiment.

Referring to FIG. 10, the outer panel 120 may include the speaker 260, the microphone 270, and the communication unit 280. At least one speaker 260 may be mounted on the side of the outer panel 120. The speaker 260 may generate a voice, an alarm sound, etc. necessary for operating the cooking appliance. In addition, the speaker 260 may generate all voices, alarm sounds, etc. for the door 20 including the display unit 110 of the door 20 to serve as an Internet of Things hub.

The microphone 270 may be mounted at the top of the outer panel 120 and may receive the user's voice. The user may input voice commands to operate the cooking appliance through the microphone 270. In addition, the microphone 270 may play a part of the role for the door 20 to serve as an Internet of Things hub.

The communication unit 280 may be mounted on the outer panel 120 at a location spaced apart from the speaker 260 and the microphone 270. Since the door 20 serves as an Internet of Things hub, the communication unit 280 provided in the door 20 is appropriately provided to perform various types of wired or wireless communication functions.

Accordingly, a plurality of communication units 280 may be provided, and each communication unit 280 may be provided as a device corresponding to a different communication method.

For example, the communication unit 280 may be provided as a wireless communication device, and each communication unit 280 may be provided as any one of a ZigBee communication device, a Wi-Fi communication device, a jet wave communication device, and a Bluetooth communication device. However, the communication method of the communication unit 280 is not limited thereto, and the communication unit 280 may also be provided as a wired communication device.

Meanwhile, the control board 290 for controlling the cooking appliance may be mounted on the outer panel 120. A control unit configured to control the cooking appliance may be implemented on the control board 290.

The outer panel 120 may be provided with a holder 120a, an opening hole 120b, a first through hole 120c, a second through hole 120d, a mounting guide 120e, and a fitting projection 120f.

The holder 120a may be provided to support the speaker 260. The holder 120a may be formed to protrude from an inner wall of the outer panel 120, a part of which may have an arc shape to correspond to a circular shape of the speaker 260.

The speaker 260 may be mounted on the holder 120a and provided on the outer panel 120. Since a pair of speakers 260 are provided, a pair of holders 120a may also be provided and formed at a location corresponding to each of the pair of speakers 260.

The opening hole 120b may be formed to pass through the bottom of the outer panel 120. The first camera 210 may be disposed at a location adjacent to the opening hole 120b to be able to view the lower side of the outer panel 120 through the opening hole 120b.

The first through hole 120c may be formed in the side of the outer panel 120. The first through hole 120c may be provided adjacent to a location where the speaker 260 is disposed. The first through hole 120c may allow the speaker 260 to communicate with the outside and at the same time, may be formed in a mesh shape in order to suppress the speaker 260 from being exposed to the outside.

The speaker 260 may communicate with the outside of the outer panel 120 through the first through hole 120c to effectively transmit an alarm and other voices to the user. Since a pair of speakers 260 are provided, a pair of first through holes 120c may also be provided and formed at a location corresponding to each of the pair of speakers 260.

The second through hole 120d may be formed in a lower portion of one side of the outer panel 120 to pass through the outer panel 120. A part of the button device 300 mounted inside the outer panel 120 through the second through hole 120d may be exposed to the outside of the outer panel 120. The user may manipulate the button device 300 by contacting the exposed portion of the outer panel 120.

The mounting guide 120e may be formed on the inner wall of the outer panel 120 to support the plurality of communication units 280. Accordingly, the mounting guide 120e may be provided in the same number as the plurality of communication units 280. The mounting guide 120e may guide the communication unit 280 to be mounted on the outer panel 120.

For example, the mounting guide 120e may be provided so that a projection having a shape corresponding to the edge of the communication unit 280 is formed on the inner wall of the outer panel 120. Each of the plurality of mounting guides 120e may be provided to have a shape and size corresponding to the shape and size of each of the plurality of communication units 280.

The fitting projection 120f may be formed to protrude from the inner wall of the outer panel 120. A plurality of fitting projections 120f may be provided and disposed to be spaced apart from each other. The control board 290 may be fitted into the fitting projections 120f. For example, the fitting projection 120f may be disposed at a location adjacent to the edge of the plate-shaped control board 290.

Accordingly, the control board 290 may have corners fitted into the fitting projections 120f and may be mounted on the outer panel 120. A shape fitting structure corresponding to the shape of the control board 290 may be formed on the fitting projection 120f so that the corner of the control board 290 is fitted.

As shown in FIG. 8, the first outlet 123 may be disposed on the upper portion of the outer panel 120, and the second outlet 124 may be disposed on the lower portion of the outer panel 120. The first outlet 123 may be disposed on the upper portion of the outer panel 120, and the air flowing by the blowing device 150 may be discharged to the outside. The second outlet 124 may be disposed on the lower portion of the outer panel 120, and the air flowing by the blowing device 150 may be discharged to the outside.

Meanwhile, referring to FIG. 3B, when the door 20 is assembled, the first outlet 123 and the second outlet 124 may be partially blocked by the baffle 190 and the front cover 200. At this time, holes for discharging air may be formed at locations corresponding to the first outlet 123 and the second outlet 124 in the baffle 190.

The first outlet 123 may be provided at a location adjacent to an upper end of the display unit 110, and the second outlet 124 may be provided at a location adjacent to a lower end of the display unit 110. Accordingly, the air forcibly flowing inside the door 20 by the blowing device 150 may be discharged to the outside at locations adjacent to the upper and lower ends of the display unit 110 through the first outlet 123 and the second outlet 124.

The air discharged through the first outlet 123 may form the air curtain on the upper portion of the door 20. In addition, the air discharged through the second outlet 124 may form the air curtain on the lower portion of the door 20.

The air curtain means a means for blocking the permeation of an external airflow into the door 20. In the embodiment, a boundary surface or a boundary zone in which the flow of air discharged from the inside of the door 20 through the first outlet 123 and the second outlet 124 forms a boundary against the flow of the external air may be referred to as an air curtain.

The air curtain formed by the air discharged from the inside of the door 20 through the first outlet 123 and the second outlet 124 may suppress the permeation of external air into the door 20.

Since the heating cooking device is disposed below the cooking appliance, the heat generated when the heating cooking device is used and the oil mist generated from the food being cooked may rise and permeate into the cooking appliance.

The heat transmitted from the heating cooking device to the cooking appliance may damage parts of the door 20 provided in the cooking appliance. In particular, parts in which the display unit 110 and circuits, elements, etc. related to its operation are embedded may be vulnerable to heat.

In addition, the oil mist transmitted from the food being cooked may be attached to the door 20 provided in the cooking appliance. The oil mist may be attached to the surface of the display unit 110 to lower the image quality of the display unit 110, and attached to the surfaces of other parts mounted on the door 20 to damage these parts.

In the embodiment, the airflow discharged to the outside of the door 20 through the first outlet 123 and the second outlet 124 provided in the door 20 forms the air curtain, so that the heat and oil mist rising from the heating cooking device disposed below the cooking appliance can be effectively blocked by the air curtain.

Accordingly, it is possible to effectively suppress various electronic parts including the display unit 110 provided in the door 20 from being damaged or degraded by the heat and the oil mist.

Referring to FIG. 11, the air guide 140 may include an inlet 141 and a mounting hole 142. The inlet 141 may be disposed on an upper portion of the air guide 140, external air may be introduced through the inlet 141, and may have the outside air introduced therethrough, and at least one inlet 141 may be provided.

The inlet 141 may be disposed at a location corresponding to the first aperture 121 provided on the upper portion of the outer panel 120. Accordingly, the external air may pass through the first aperture 121 of the outer panel 120 to flow into the door 20 through the inlet 141.

The mounting hole 142 may be formed in a lower portion of the inlet 141 in the air guide 140, and the blowing device 150 may be mounted therein. The mounting hole 142 may be formed to pass through the air guide 140 in the front-rear direction of the door 20.

The inlet 141 may be formed in the up-down direction of the air guide 140, and the mounting hole 142 may be formed in the front-rear direction of the air guide 140. This structure may allow the air introduced through the inlet 141 to flow in the up-down direction of the air guide 140 and then flow in the front-rear direction of the air guide 140 due to a change in the flow path.

In other words, air may flow from the upper portion to the lower portion of the air guide 140 through the inlet 141, and its direction may be changed, so that the air may flow from the rear to the front of the air guide 140 through the mounting hole 142.

The blowing device 150 may include a casing 151 and the blowing fan 152. The casing 151 may be disposed in the mounting hole 142 and formed with a hollow, and the blowing fan 152 may be mounted in the hollow.

The blowing fan 152 may be rotatably mounted in the casing 151, and may flow air from the rear to the front of the air guide 140. The blowing fan 152 may receive electricity and rotate to flow air inside the door 20.

By the rotation of the blowing fan 152, external air may flow into the door 20 through the inlet 141, and may be discharged to the outside of the door 20 through the first outlet 123 and the second outlet 124. The mounting hole 142 of the air guide 140 may be formed in the middle of the casing 151 and formed to correspond to the location, area, and shape of the hollow in which the blowing fan 152 is disposed.

Referring to FIG. 7, the air guide 140 and the inner panel 130 may form a first space 20a in which the inlet 141 is formed by being coupled to each other, and a second space 20b disposed below the first space 20a and in which the blowing device 150 is mounted.

The air introduced into the door 20 may flow in the first space 20a in the up-down direction of the door 20 and then flow in the front-rear direction of the door 20 in the second space 20b due to a change in the flow path to pass through the mounting hole 142 of the air guide 140.

A third space 20c through which the air passing through the blowing fan 152 provided in the blowing device 150 is introduced and distributed to flow toward the first outlet 123 and the second outlet 124 may be formed between the air guide 140 and the outer panel 120.

The front of the third space 20c is closed by the display unit 110 and the like. Accordingly, the air introduced into the third space 20c through the blowing fan 152 may be branched to flow upward and downward, and the branched air may be discharged to the outside of the door 20 through the first outlet 123 and the second outlet 124.

Hereinafter, the airflow inside the door 20 will be described in detail with reference to FIG. 7. In FIG. 7, the airflow is indicated by arrows. The air introduced into the third space 20c through the mounting hole 142 is branched to flow upward and downward, and branched air is discharged to an outside of the door 20 through the first outlet 123 and the second outlet 124.

As the blowing fan 152 rotates, external air may flow into the door 20 through the inlet 141 of the air guide 140, and flow to be discharged to the outside of the door 20 through the first outlet 123 and the second outlet 124.

The air forcibly flowing by the blowing fan 152 may specifically have the following flow path of the airflow.

The air may flow into the door 20 from the first aperture 121 of the outer panel 120 and the inlet 141 provided at a location corresponding thereto. The air flowing into the door 20 may flow in a downward direction of the door 20 to flow into the blowing fan 152.

The air may pass through the blowing fan 152 in the front-rear direction of the door 20. At this time, the air may pass through the mounting hole 142 of the air guide 140 while passing through the blowing fan 152. The flow direction of the air in the blowing fan 152 may be changed from the up-down direction of the door 20 to the front-rear direction thereof.

Since the front of the mounting hole 142 is blocked by the display unit 110, the air passing through the mounting hole 142 may be branched in the up-down direction in front of the air guide 140.

A part of the branched air may flow in an upward direction of the door 20 and may be discharged through the first outlet 123. The other part of the branched air may flow in a downward direction of the door 20 and may be discharged through the second outlet 124.

The air may flow downward through the inlet 141 to be introduced into the first space 20a inside the door 20. The flowing direction of the air may be changed to the front-rear direction of the air guide 140 in the second space 20b and thus the air may pass through the mounting hole 142.

Since the front of the third space 20c is closed, the air introduced into the third space 20c through the mounting hole 142 may be branched to flow in the third space 20c in the up-down direction and discharged to the outside of the door 20 through the first outlet 123 and the second outlet 124. This structure can allow the air to flow through the entire third space 20c to be discharged to the outside of the door 20 at a location adjacent to the top and bottom of the display unit 110.

The air branched from the first outlet 123 and the second outlet 124 may surround the entire door 20. In particular, the branched air may surround the front surface of the door 20. This structure can allow the air discharged from the first outlet 123 and the second outlet 124 to form the air curtain on the door 20, thereby effectively suppressing the heat and oil mist generated from the heating cooking device disposed below the cooking appliance from permeating into the door 20.

Meanwhile, at least a part of the air discharged from the first outlet 123 may come into contact with the front surface of the display unit 110 while moving downward by gravity to cool the display unit 110.

In addition, the above-described airflow structure inside the door 20 may allow the air flowing into the door 20 to flow through the entire inside of the door 20. For example, the air may flow in the entire space formed by the rear surface of the display unit 110 and the outer panel 120.

Accordingly, the air flowing inside the door 20 may cool the entire rear surface of the display unit 110, and effectively cool the outer panel 120 and other parts mounted on other portions of the door 20.

In particular, the outer panel 120 may be provided with parts that generate heat, such as the speaker 260, the microphone 270, the communication unit 280, and the control board 290. These heat-generating parts may be disposed over the entire outer panel 120. Accordingly, the air may flow through the entire inside of the outer panel 120, thereby effectively cooling these heat-generating parts.

As shown in FIG. 7, the first aperture 121 and the inlet 141 into which air flows may communicate with each other. As the blowing fan 152 rotates, the external air may flow into the air guide 140 through the first aperture 121 and the inlet 141 to flow toward the blowing device 150 through the space formed by the inner panel 130 and the air guide 140.

The air may flow toward the blowing fan 152 of the blowing device 150 in the space formed by the shielding plate 160. The air may pass through the blowing fan 152 and collide with the rear surface of the display unit 110 disposed to face the blowing fan 152 to cool the display unit 110.

After the air passing through the blowing fan 152 collides with the rear surface of the display unit 110, the flow may be branched in the upward and downward directions of the display unit 110. The air directed to the upper side of the display unit 110 may be discharged to the outside of the door 20 through the first outlet 123 provided on the upper portion of the outer panel 120. The air directed to the lower side of the display unit 110 may be discharged to the outside of the door 20 through the second outlet 124 provided on the lower portion of the outer panel 120.

In the embodiment, the air flowing inside the door 20 can cool the entire front surface of the display unit 110 while being discharged through the first outlet 123. In addition, the air flowing inside the door 20 can effectively cool the heat-generating parts mounted on the rear surface of the display unit 110 and inside the door 20.

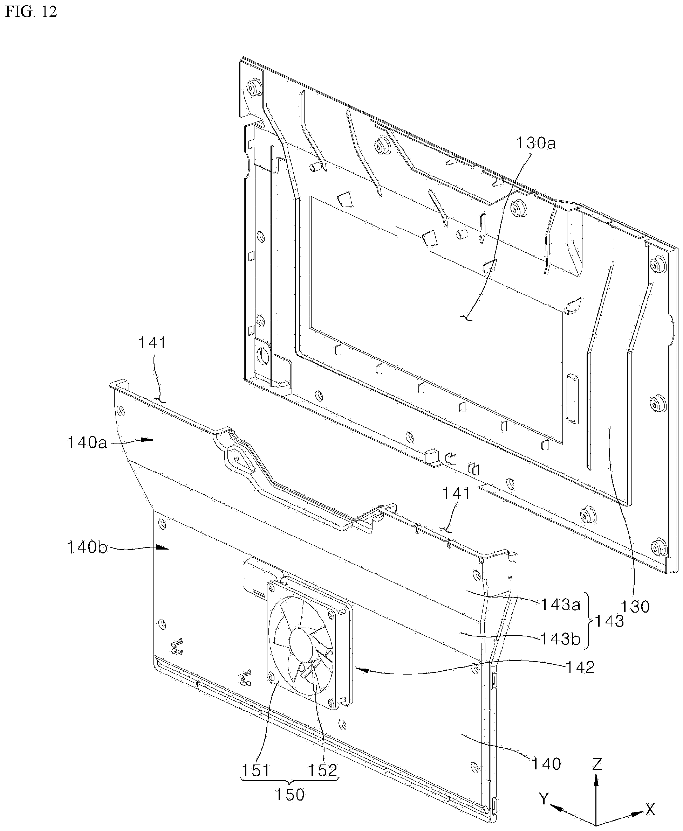

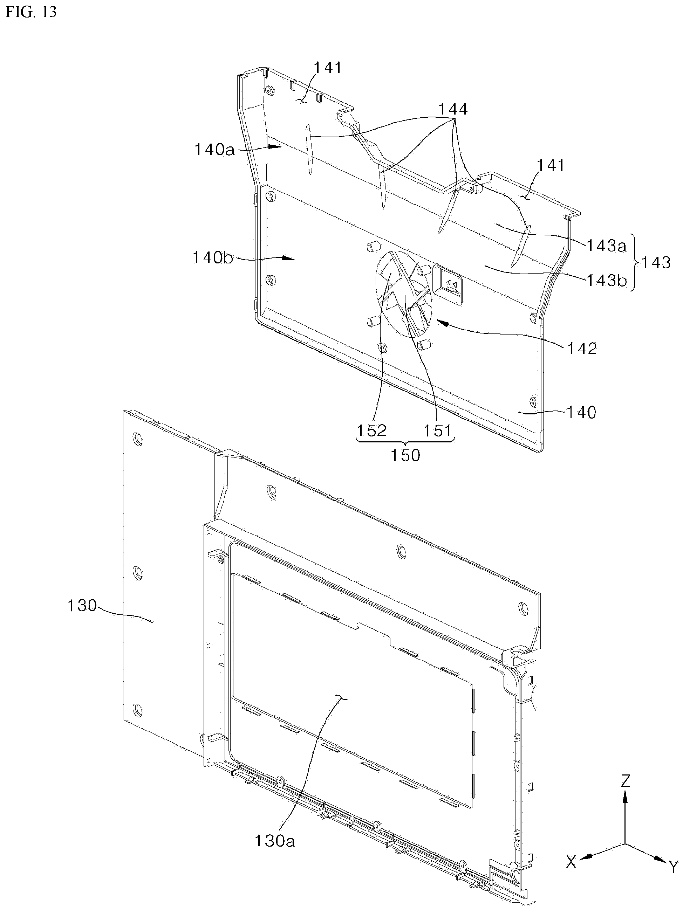

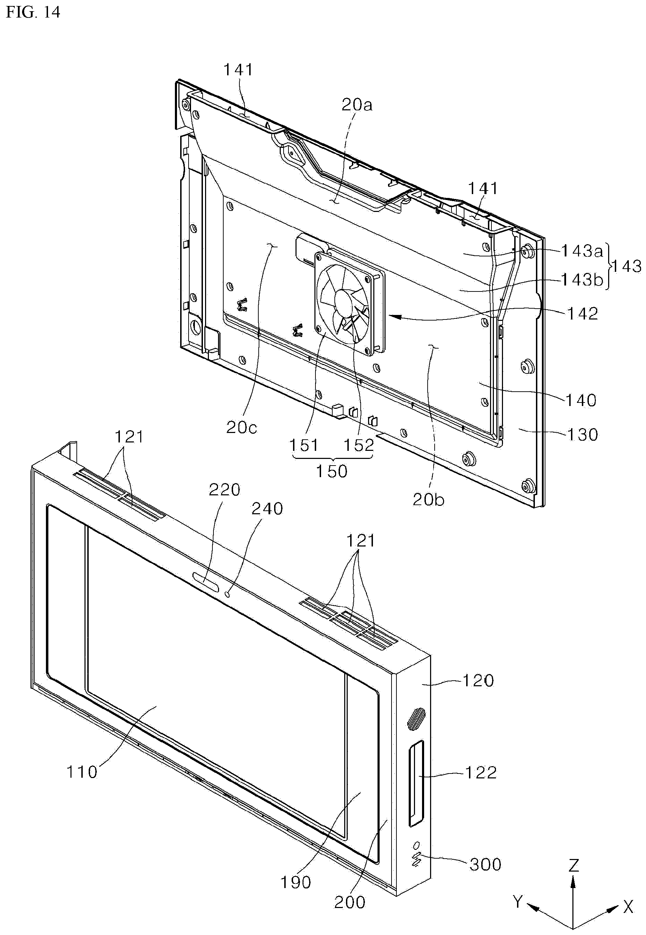

FIG. 12 is an exploded perspective view of FIG. 11. FIG. 13 is a view of FIG. 12 from another direction. FIG. 14 is an exploded perspective view showing the inner panel 130 and the air guide 140 in the door 20.

Referring to FIG. 13, the mounting hole 142 may be formed in the middle of the air guide 140. The casing 151 has a hollow having a location, size, and shape corresponding to the mounting hole 142, and the blowing fan 152 may be disposed in the hollow. The casing 151 may be disposed at a location corresponding to the hollow and the mounting hole 142 of the air guide 140 and mounted on one surface of the air guide 140.

A hollow 130a may be formed in the inner panel 130. Since the hollow 130a of the inner panel 130 is blocked by the shielding plate 160, the air introduced through the inlet 141 may not leak into the hollow 130a of the inner panel 130. Accordingly, the inner panel 130 and the shielding plate 160 together may form the flow path of the air through which the air cooling the inside of the door 20 flows.

For the user's convenience and aesthetic sense, the door 20 needs to be manufactured in a slim shape by reducing the width in the front-rear direction. However, as the cross-sectional area of the inlet 141 through which air is introduced increases, the air can be smoothly introduced into the door 20, and the cooling effect and the air curtain forming effect of the door 20 can be increased.

Hereinafter, a structure of the door 20 that is slim as a whole and has an expanded cross-sectional area of the inlet 141 will be described in detail with reference to FIGS. 11 to 14. Referring to FIGS. 11 and 12, a cross-section area of the first space 20a may be provided to increase from the bottom toward the top of the door 20. Accordingly, the cross-sectional area of the first space 20a may be maximized at an upper end of the first space 20a, that is, at the inlet 141.

Since the third space 20c is bounded by the first space 20a and the air guide 140, a shape of the third space 20c may have a tendency opposite to a shape of the first space 20a. Accordingly, the cross-sectional area of the third space 20c may be provided to increase from the bottom toward the top of the door 20 at a boundary point between the first space 20a and the second space 20b.

At this time, the mounting hole 142 may communicate the second space 20b with the third space 20c, and the blowing fan 152 may flow the air from the second space 20b to the third space 20c.

Due to the above-described structure, when looking at the air guide 140 from the top of the air guide 140, the cross-sectional area of the first space 20a including the inlet 141 can be provided to be greater than the cross-sectional area of the second space 20b.

Since the cross-sectional area of the inlet 141 and the first space 20a increases, external air may smoothly flow into the first space 20a through the inlet 141. Accordingly, air can be smoothly introduced into the door 20, and the cooling effect and the air curtain forming effect of the door 20 can be increased.

The air guide 140 may include an inclined portion 143 disposed to be inclined in the up-down direction to increase the cross-sectional area of the first space 20a from the bottom toward the top of the air guide 140. The inclined portion 143 may include a first end 143a and a second end 143b.

The first end 143a may be formed at an upper portion of the inclined portion 143, and provided to have a relatively gentle inclination. The second end 143b may be formed at a lower portion of the inclined portion 143, connected to the first end 143a, and provided to have a steeper inclination compared to the first end 143a.

Referring to FIG. 13, the air guide 140 may include a guide fin 144 provided to protrude from an inner wall of the air guide 140 at a location where the first space 20a is formed, disposed so that a longitudinal direction faces the mounting hole 142, and guiding the air introduced into the inlet 141 to flow into the mounting hole 142.

The guide fin 144 may be formed so that the longitudinal direction is slightly inclined with respect to the up-down direction of the air guide 140 to be placed toward the mounting hole 142 from the top toward the bottom. Accordingly, the air introduced through the inlet 141 may be guided by the guide fin 144 to smoothly move toward the mounting hole 142.

In the embodiment, the guide fin 144 may be mounted on the air guide 140 to guide the flow of the air, and thus the air introduced through the inlet 141 may be smoothly moved to the mounting hole 142.

The air guide 140 may include an upper portion 140a in which the inlet 141 is formed and a lower portion 140b in which the blowing device 150 is disposed. When the air guide 140 and the inner panel 130 are coupled, the lower portion 140b may be generally disposed at a location corresponding to the hollow 130a of the inner panel 130.

When looking at the air guide 140 from the upper portion of the door 20, a cross-sectional area of the upper portion 140a of the air guide 140 may be formed to be greater than a cross-sectional area of the lower portion 140b. As the cross-sectional area of the upper portion 140a is expanded, the cross-sectional area of the inlet 141 may also be expanded. Accordingly, in the air guide 140, the inlet 141 into which air flows is expanded, so that external air may easily flow into the air guide 140.

Meanwhile, the lower portion 140b of the air guide 140 has a smaller cross-sectional area than that of the upper portion 140a, but the lower portion 140b of the air guide 140 corresponds to the hollow 130a of the inner panel 130, thus, the airflow space in the portion corresponding to the lower portion 140b may be expanded toward the shielding plate 160 by the hollow 130a of the inner panel 130. As a result, the lower portion 140b of the air guide 140 may also have a shape in which the airflow space is expanded by the hollow 130a of the inner panel 130.

In other words, the lower portion 140b of the air guide 140 corresponding to the hollow 130a of the inner panel 130 is formed to have a smaller cross-sectional area than that of the upper portion 140a of the air guide 140, but the flow space of the lower portion 140b of the air guide 140 may be expanded to the shielding plate 160 by the hollow 130a of the inner panel 130.

Accordingly, the upper portion 140a and the lower portion 140b of the air guide 140 may have the shape of an expanded cross-sectional area due to the above-described structure. Accordingly, the airflow space formed by coupling the air guide 140 and the inner panel 130 in the structure in which the air guide 140 and the inner panel 130 are coupled may be sufficiently wide, and the air may be smoothly introduced from the outside and may also smoothly pass through the blowing device 150 mounted on the lower portion 140b of the inner panel 130.

In addition, due to the decrease in the cross-sectional area of the lower portion 140b of the air guide 140, conversely, the space in which the air passing through the blowing device 150 is discharged from the lower portion 140b of the air guide 140 may be expanded. At this time, the air passing through the blowing device 150 may pass through the hollow 1201 of the outer panel 120 and come into contact with the display unit 110 to cool the display unit 110.

The above-described structure can allow the door 20 to have a slim overall structure and increase the flow rate of air flowing therein, thereby improving cooling efficiency of the door 20.
As described above, the present invention has been described with reference to the exemplary drawings, but it is apparent that the present invention is not limited by the embodiments and drawings disclosed in this specification, and various modifications may be made by those skilled in the art without departing from the technical idea of the present invention. In addition, although the operations and effects according to the configuration of the present invention have not been explicitly disclosed and described while describing the embodiments of the present invention, it goes without saying that the predictable effects by the corresponding configuration should also be recognized.

## Claims

1. A cooking appliance comprising:
a main body (10) in which a cavity (11) is formed, and
a door (20) for opening and closing the cavity (11),
wherein the door (20) includes:
a display module (21) on a front surface of the door (20), and
a cooling flow path unit (22) at a rear surface of the display module (21), the cooling flow path unit (22) includes a flow path for guiding cooling air for cooling the display module (21) and an inner panel (130) disposed behind the display module (21), and
wherein the cooling flow path unit (22) includes an air guide (140) configured to guide the air and a blowing device (150) mounted on the air guide (140), and
wherein the air guide (140) is disposed between the display module (21) and the inner panel (130).

2. The cooking appliance of claim 1, wherein the door (20) includes an outer panel (120) and the display module (21) includes a display unit (110) configured to display videos and/or images, the display unit (110) being mounted on a front surface of the outer panel (120), and
wherein the air guide (140) is disposed between the outer panel (120) and the inner panel (130), and coupled to the inner panel (130).

3. The cooking appliance of claim 1 or 2, wherein the air guide (140) includes at least one inlet (141) disposed on an upper portion of the air guide (140), and a mounting hole (142) which is formed below the inlet (141) and in which the blowing device (150) is mounted,
wherein the inlet (141) is formed to pass through the air guide (140) in vertical direction, and
the mounting hole (142) is formed to pass through the air guide (140) in a front-rear direction.

4. The cooking appliance according to any one of the preceding claims in combination with claim 2, wherein the outer panel (120) includes a first outlet (123) disposed on an upper portion of the door (20) for discharging the cooling air to an outside, and/or a second outlet (124) disposed on a lower portion of the door (20) for discharging the cooling air to the outside.

5. The cooking appliance of claim 4, wherein the first outlet (121) and/or the second outlet (124) is configured for discharging the cooling air in forward direction.

6. The cooking appliance according to any one of the preceding claims, wherein the cooling flow path unit (22) is configured to guide air introduced at an upper surface of the door towards a rear surface of the display module (21), such that the air flows in an upward and a downward direction along the rear surface of the display module (21) for cooling the same before being discharged to an outside of the door (20).

7. The cooking appliance according to any one of the preceding claims in combination with claim 2, wherein the outer panel (120) includes a first aperture (121) formed in an upper surface thereof corresponding to the inlet (141) of the air guide (140) to allow external air to be introduced through the upper surface of the outer panel (120) into the air guide (140).

8. The cooking appliance according to any one of the preceding claims in combination with claim 4, wherein the air guide (140) is coupled to the inner panel (130) to form a first space (20a), the inlet (141) being formed between the air guide (140) and the inner panel (130), and to form a second space (20b) below the first space (20a) and in which the blowing device (150) is mounted.

9. The cooking appliance of claim 8, wherein a third space (20c) is formed between the air guide (140) and the outer panel (120) and is configured to distribute air introduced by the blowing device (150) into the third space (20c) to flow toward the first outlet (123) and the second outlet (124).

10. The cooking appliance of claim 9, wherein a cross-sectional area of the first space (20a) increases towards an upper side of the air guide (140), and/or
a cross-sectional area of the third space (20c) increased from the mounting hole (142) towards an upper side of the air guide (140).

11. The cooking appliance of claim 9 or 10, wherein the mounting hole (142) and/or the second space (20b) communicates the first space (20a) with the third space (20c), and the blowing device (150) is configured to blow the air from the first space (20a) to the third space (20c).

12. The cooking appliance according to any one of claims 9 to 11, wherein air introduced into the door (20) flows in the first space (20a) in the up-down direction of the door (20) and then flow in the front-rear direction of the door (20) in the second space (20b) due to a change in the flow path to pass through the mounting hole (142) of the air guide (140).

13. The cooking appliance of claim 12, wherein the air introduced into the third space (20c) through the mounting hole (142) is branched to flow upward and downward, and branched air is discharged to an outside of the door (20) through the first outlet (123) and the second outlet (124).

14. The cooking appliance of claim 4, wherein air flows into the inlet (141) and flows along the flow path to cool the rear surface of the display unit (110), and then flows along the flow path and is discharged to the outside through the first outlet (123) and the second outlet (124).

15. The cooking appliance according to any one of the preceding claims, wherein the inner panel (130) and the air guide (140) are coupled to each other to form the flow path of air.
